# FASCICULE DE BREVET EUROPEEN

(11) **EP 3 147 675 B1**
(45) Date de publication et mention de la délivrance du brevet: **25.03.2026**
(21) Numéro de dépôt: 16185073.0
(22) Date de dépôt: 22.08.2016
(51) Int. Cl.: G01R 1/04, G01R 15/14, G01R 19/00, H01R 13/66, H02B 13/00, H02B 13/035, G01R 15/18, H01R 13/53

(54) **DISPOSITIF DE MESURE POUR CELLULE D'APPAREILLAGE HAUTE TENSION**
MESSVORRICHTUNG FÜR HOCHSPANNUNGSGERÄTEZELLE
MEASURING DEVICE FOR A HIGH-VOLTAGE SWITCHGEAR

(30) Priorité: 17.09.2015 FR 1558745
(43) Date de publication de la demande: 29.03.2017
(73) Titulaire: Schneider Electric Industries SAS, 92500 Rueil-Malmaison (FR)
(72) Inventeur: Perez Quesada, Juan Carlos, 48100 Mungia (ES)
(74) Mandataire: Schneider Electric

(56) Documents cités:
- EP-A1- 0 891 013
- EP-A1- 1 380 083
- EP-A1- 1 653 582
- EP-A1- 2 028 737
- EP-A1- 2 608 338
- EP-A1- 2 634 875
- EP-A2- 1 391 740
- JP-A- H06 222 086
- US-A1- 2005 135 030
- US-B1- 6 227 908
- LAURI KUMPULAINEN ET AL: "Preemptive Arc Fault Detection Techniques in Switchgear and Controlgear", IEEE TRANSACTIONS ON INDUSTRY APPLICATIONS, IEEE SERVICE CENTER, PISCATAWAY, NJ, US, vol. 49, no. 4, 1 July 2013 (2013-07-01), pages 1911 - 1919, XP011520307, ISSN: 0093-9994, DOI: 10.1109/TIA.2013.2258314
- JAKEL B W ET AL: "Transients in medium voltage switchgear: measurements, models and coupling", 19991206; 19991206 - 19991208, 6 December 1999 (1999-12-06), pages 69 - 74, XP010513248
- KORNHUBER S ET AL: "Partial discharge (PD) detection on medium voltage switchgears using non-invasive sensing methods", CONDITION MONITORING AND DIAGNOSIS (CMD), 2012 INTERNATIONAL CONFERENCE ON, IEEE, 23 September 2012 (2012-09-23), pages 392 - 395, XP032312847, ISBN: 978-1-4673-1019-2, DOI: 10.1109/CMD.2012.6416462

## Description

### Domaine technique de l'invention

L'invention se rapporte à un dispositif de mesure destiné à être raccordé à une barre conductrice d'une cellule d'appareillage d'un réseau électrique haute tension. Dans le présent document, le terme «haute tension» couvre les domaines de la Moyenne Tension (MT) et de la Haute Tension A (HTA), c'est-à-dire typiquement les tensions comprises entre 1 kVolt et 50 kVolts. Le dispositif de mesure est adapté pour des cellules d'appareillage opérant dans le vide, dans l'air ou dans un gaz.

### Etat de la technique

La connaissance et la mesure de différents paramètres physiques ou électriques devient un aspect vital dans les installations de distribution électrique haute tension, non seulement pour des raisons d'amélioration des opérations de maintenance, mais aussi pour la mise en place et la gestion de réseaux électriques connectés, multi-sources et intelligents, appelé aussi smart grids. Parmi les paramètres importants à connaître pour effectuer une gestion efficace de l'énergie, on peut citer la mesure de tension et la mesure de courant circulant dans les barres conductrices, ainsi que la mesure de température au niveau des barres conductrices.

Un des enjeux majeurs est donc de pouvoir adapter les cellules d'appareillage aux nouvelles exigences des smart grids, en particulier dans les installations de distribution électrique existantes.

Un tableau modulaire d'appareillage de distribution est composé de plusieurs cellules d'appareillage haute tension placées les unes à côté des autres. En fonction des besoins de l'installation, ces cellules réalisent des fonctions diverses telles que interrupteur, interrupteur fusible, disjoncteur, sectionneur, contacteur, arrivée/départ câbles, transformateur HT/BT, etc..., et sont raccordées entre elles par un bus de barres conductrices (trois barres conductrices pour une cellule triphasée).

Les documents EP0520933A1 et EP0891013A1 décrivent des interfaces de raccordement pour raccorder deux cellules d'appareillage haute tension entre elles à l'aide de manchons de connexion. Ce type de dispositif d'extension est fréquemment utilisé car il permet d'assembler facilement plusieurs cellules d'appareillage haute tension entre elles. Habituellement, chaque cellule comporte donc systématiquement de chaque côté une interface de raccordement standard qui lui permettra de s'insérer facilement dans un tableau d'appareillage modulaire.

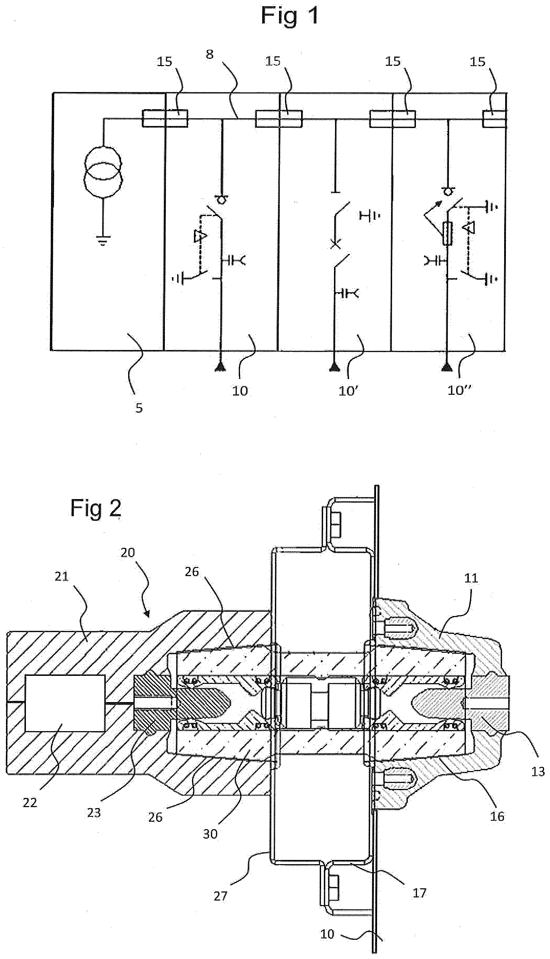

Il existe aussi des cellules qui sont adaptées pour mesurer la tension dans les barres conductrices haute tension. Un exemple d'une telle cellule de mesure, appelée cellule de comptage (ou VTC Voltage Transformer Cubicle), inclut un transformateur inductif de tension qui doit être raccordé à une barre conductrice pour la mesure de tension. Comme toute cellule débrochable, elle peut se raccorder à une interface de raccordement standard d'une cellule d'appareillage adjacente à l'aide de manchons de connexion, de façon à pouvoir mesurer directement la tension des barres conductrices (voir figure 1).

Néanmoins, les mesures effectuées par ces cellules ne sont pas toujours suffisamment performantes pour les exigences des smart grids (problème de ferrorésonance ou de saturation). De plus, les cellules de comptage sont encombrantes et lourdes à installer. Elles ne sont donc pas adaptées lors des opérations de mise à niveau ou de rénovation (retrofit), lorsqu'on veut par exemple remplacer ou rajouter une fonction de mesure de tension dans une installation déjà existante, car l'encombrement nécessaire à la mise en place d'une telle cellule de mesure n'existe pas toujours.

Les documents WO2005008854A1 et EP1380083A1 décrivent aussi des interfaces de raccordement de deux cellules d'appareillage haute tension entre elles à l'aide de manchons de connexion. Ces interfaces comportent en plus la possibilité d'introduire un système de mesure de tension/courant au niveau des manchons de connexion, en utilisant un détecteur capacitif ou un tore, par exemple un tore de Rogowski.

Cependant, ces systèmes de mesure nécessitent des traitements électroniques supplémentaires car ils peuvent générer des problèmes de précision des mesures, en particulier à cause de la variation de la permittivité et du facteur de dissipation engendrés par les matériaux isolants utilisés, lorsque la température et la tension varient.

Le but de l'invention est donc de proposer un système de mesure simple, performant, économique et facile à mettre en œuvre, en particulier dans le cadre d'une rénovation d'une installation existante, et qui ne présente les inconvénients cités cidessus.

### Exposé de l'invention

Ce but est atteint grâce à un tableau d'appareillage modulaire haute tension selon la revendication 1. Des modes de réalisation avantageux de l'invention sont décrits dans les revendications dépendantes.

### Brève description des figures

D'autres caractéristiques et avantages vont apparaître dans la description détaillée qui suit faite en regard des dessins annexés dans lesquels :
- la figure 1 représente une vue schématique d'un exemple de solution existante utilisant une cellule de comptage pour la mesure de tension,
- la figure 2 montre une vue en coupe longitudinale d'un premier mode de réalisation d'un dispositif de mesure selon l'invention,
- la figure 3 est une vue en coupe longitudinale d'un autre mode de réalisation du dispositif de mesure,
- la figure 4 représente une vue simplifiée en perspective d'une cellule d'appareillage avec trois dispositifs de mesure,
- la figure 5 montre une alternative d'un ensemble de mesure.

### Description détaillée d'un mode de réalisation

La figure 1 montre un schéma classique d'une partie d'un tableau d'appareillage modulaire haute tension qui comprend trois cellules d'appareillage 10, 10', 10". Les cellules 10, 10', 10" sont placées les unes à côté des autres, et comportent un jeu de barres conductrices 8. Elles sont reliées à l'aide d'interfaces de raccordement standardisées 15, ce qui permet aisément de les fixer mécaniquement entre elles et de connecter électriquement les jeux de barres conductrices 8.

Ainsi, lors de la conception du tableau modulaire, cette architecture permet de facilement ajouter une ou plusieurs cellules supplémentaires en fonction des besoins fonctionnels de l'installation. Ces cellules supplémentaires seront placées par exemple à droite de la cellule 10" et connectées avec une interface de raccordement standard 15. Les cellules 10, 10', 10" montrent respectivement des fonctions interrupteur, disjoncteur et interrupteur fusible, mais il est bien évident que d'autres fonctions sont possibles.

La figure 1 montre également une cellule de comptage 5 traditionnelle de type VTC qui est adaptée pour mesurer la tension dans les barres conductrices 8, grâce à un transformateur de tension inductif. Comme pour toute autre cellule, cette cellule de comptage 5 est raccordée aux autres cellules par une interface de raccordement 15, mais est néanmoins encombrante et il est notamment difficile de l'ajouter dans un tableau modulaire déjà existant.

La figure 2 montre un dispositif de mesure 20 selon l'invention assemblé à une cellule 10. Il comporte une enveloppe 21 qui entoure un circuit électrique de mesure 22. Le circuit électrique 22 comprend les composants électriques et électroniques nécessaires pour permettre de mesurer la grandeur physique souhaitée (tension, température,...) et est raccordé à un conducteur de puissance 23 central du dispositif de mesure 20.

L'enveloppe 21 est réalisée en matériau isolant, par exemple une résine isolante polymérique ou une résine époxy, et présente, sur une face, une cavité de forme tronconique 26 (c'est-à-dire en forme de cône tronqué) qui est adaptée pour coopérer avec une forme tronconique complémentaire d'une première extrémité d'un manchon de connexion 30 de l'interface de raccordement 15, cette forme tronconique étant par exemple en matériau élastomère. Le conducteur de puissance 23 dépasse de l'enveloppe 21 au centre de la cavité tronconique 26, afin de pouvoir assurer une connexion précise et efficace avec un élément conducteur central dans le manchon de connexion 30. Cet élément conducteur peut par exemple comprendre des pinces d'embrochage pour assurer un bon contact électrique.

L'interface de raccordement 15 de la cellule 10 comporte un corps isolant 11 qui possède également une cavité de forme tronconique 16 coopérant avec une forme tronconique complémentaire d'une seconde extrémité du manchon de connexion 30. Un conducteur de puissance 13 dépasse du corps isolant 11 au centre de la cavité tronconique 16 afin de pouvoir assurer une connexion précise et efficace avec l'élément conducteur central du manchon de connexion 30. Le conducteur de puissance 13 est par ailleurs directement raccordé avec une barre conductrice 8 de la cellule 10. Les cavités tronconiques 16 et 26 sont de forme similaire puisque les manchons de connexion sont préférentiellement symétriques.

Le dispositif de mesure 20 comporte un support de fixation 27 destiné à fixer le dispositif de mesure 20 à l'interface de connexion 15 de la cellule 10. Ce support de fixation 27 est positionné devant la cavité tronconique 26 de l'enveloppe 21 et possède une ouverture centrale 28 pour laisser passer le manchon de fixation 30. L'interface de connexion 15 comporte un support métallique 17 correspondant qui coopère avec le support de fixation 27.

La forme du support métallique 17 et du support de fixation 27, ainsi que la longueur du manchon de connexion 30 sont adaptées pour maintenir une distance d'isolation suffisante lorsque la cellule 10 et le dispositif de mesure 20 sont reliés entre eux.

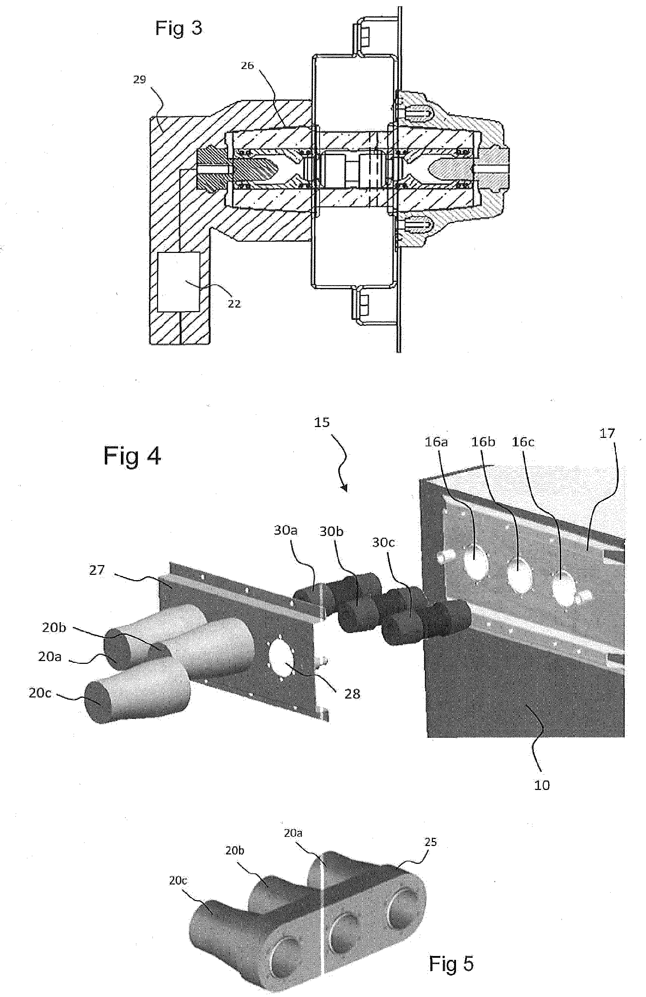

Différentes formes sont possibles pour l'enveloppe du dispositif de mesure, par exemple en L ou en T. En particulier, la figure 3 montre une variante du mode de réalisation de la figure 2. Dans cette variante, l'enveloppe 21 présente une forme coudée en L, avec un coude 29 qui est positionné entre une première partie comportant la cavité tronconique 26 et une deuxième partie comportant le circuit électrique 22. Cette variante présente l'avantage d'un encombrement global réduit du dispositif de mesure 20.

La figure 4 montre une vue simplifiée en perspective d'un ensemble de mesure comportant trois dispositifs de mesure 20a, 20b, 20c susceptibles de se raccorder respectivement à trois barres conductrices d'une cellule d'appareillage multipolaire 10 d'un réseau électrique triphasé, à l'aide d'une interface de raccordement 15. L'interface de raccordement 15 comporte trois manchons de connexion 30a, 30b, 30c, dont la première extrémité est introduite dans les cavités tronconiques des dispositifs de mesure 20a, 20b, 20c et dont la seconde extrémité est introduite dans les cavités tronconiques 16a, 16b, 16c de la cellule 10.

L'ensemble de mesure comporte un support de fixation 27 qui est alors commun pour les trois dispositifs de mesure 20a, 20b, 20c et qui comporte trois ouvertures 28 pour le passage respectivement des manchons de connexion 30a, 30b, 30c. Ce support de fixation 27 commun est susceptible de se fixer contre un support métallique 17 de l'interface de raccordement 15.

Dans ce mode de réalisation, chaque dispositif de mesure 20a, 20b, 20c est indépendant et pourrait donc en théorie mesurer des paramètres différents.

Selon une variante, l'ensemble de mesure comprend une base commune 25, réalisée en matériau isolant, et qui permet de lier entre elles les enveloppes de plusieurs dispositifs de mesure, par exemple deux ou trois dispositifs. Ainsi, la figure 5 montre un ensemble de mesure triphasé comportant trois dispositifs de mesure 20a, 20b, 20c dont les enveloppes sont liées par une base commune 25, ce qui simplifie l'ensemble en ne proposant qu'une seule pièce complète.

Comme indiqué précédemment, le dispositif de mesure 20 peut être utilisé pour mesurer différentes grandeurs physiques relatives à une barre conductrice haute tension 8. Le dispositif de mesure peut être par exemple un capteur de tension de type LPVT (Low Power Voltage Transformer) destiné à mesurer la tension de la barre conductrice, ce capteur étant réalisé par exemple à l'aide d'une technologie de type résistif, de type capacitif ou d'une combinaison des deux. Le dispositif de mesure peut aussi être un capteur de température destiné à mesurer la température au voisinage de la barre conductrice pour évaluer la charge d'une barre conductrice.

Le circuit électrique 22 du dispositif de mesure 20 est bien entendu capable de communiquer avec une unité de contrôle/commande (de type IED : Intelligent Electrical Device) ou avec un système de supervision distant, afin de transmettre les informations mesurées pour permettre la gestion du réseau électrique. Cette communication peut être filaire (non représentée sur les figures pour des raisons de simplification) ou sans fil (wireless). Lorsque la communication est filaire, elle peut également servir à alimenter le circuit électrique 22. Lorsque la communication est sans fil, une alimentation de type pile peut être intégrée dans le dispositif de mesure 20.

## Revendications

1. Tableau d'appareillage modulaire haute tension comprenant :
- une pluralité de cellules d'appareillage (10, 10', 10"), les cellules (10, 10', 10") étant placées les unes à côté des autres et comportant un jeu de barres conductrices (8), les cellules d'appareillage haute tension (10, 10', 10") étant reliées à l'aide d'interfaces de raccordement standardisées (15), et
- un dispositif de mesure (20) adapté pour être connecté à une barre conductrice du jeu de barres conductrices (8) d'une cellule d'appareillage (10) de la pluralité de cellules d'appareillage (10, 10', 10"), le dispositif de mesure comportant :
- une enveloppe (21) en matériau isolant,
- un circuit électrique (22) de mesure, et
- un conducteur de puissance (23) relié au circuit électrique (22),
**caractérisé en ce que** :
le circuit électrique (22) de mesure est intégré à l'intérieur de l'enveloppe,
et **en ce que** l'enveloppe (21) présente une cavité (26) de forme tronconique, le conducteur de puissance (23) dépassant de l'enveloppe au centre de la cavité tronconique, et **en ce que** la cavité tronconique (26) est adaptée pour coopérer avec une forme tronconique complémentaire d'une première extrémité d'un manchon de connexion (30) d'une interface de raccordement (15) de la cellule d'appareillage (10), de façon à connecter électriquement le conducteur de puissance (23) à un élément conducteur central dans le manchon de connexion (30),
et **en ce que** le dispositif de mesure (20) est adapté pour se connecter à la barre conductrice (8) de la cellule d'appareillage (10) en utilisant directement l'interface de raccordement (15) qui est placée sur les côtés de toutes les cellules d'appareillage (10, 10', 10"),
et **en ce que** ladite interface de raccordement (15) comporte un corps isolant (11) présentant une cavité de forme tronconique (16) adaptée pour coopérer avec une forme tronconique complémentaire d'une seconde extrémité du manchon de connexion (30),
et **en ce qu'**un conducteur de puissance (13) dépasse du corps isolant (11) au centre de la cavité tronconique (16), de façon à connecter électriquement le conducteur de puissance (13) à l'élément conducteur central du manchon de connexion (30),
et **en ce que** le conducteur de puissance (13) est raccordé avec la barre conductrice (8) de la cellule (10).

2. Tableau d'appareillage selon la revendication 1, **caractérisé en ce que** le dispositif de mesure est un capteur de tension du type LPVT (Low Power Voltage Transformer).

3. Tableau d'appareillage selon la revendication 1, **caractérisé en ce que** le dispositif de mesure est un capteur de température.

4. Tableau d'appareillage selon la revendication 1, **caractérisé en ce que** le dispositif de mesure (20) comprend un support de fixation (27) permettant de fixer mécaniquement le dispositif de mesure (20) à l'interface de raccordement (15).

5. Tableau d'appareillage selon la revendication 1, **caractérisé en ce que** l'enveloppe présente une forme coudée en L avec un coude (29) positionné entre une première partie comportant la cavité tronconique (26) et une deuxième partie comportant le circuit électrique (22).

6. Tableau d'appareillage selon la revendication 1, **caractérisé en ce que** l'enveloppe est en résine époxy ou polymérique.

## Patentansprüche

1. Modulare Hochspannungsschaltanlage, umfassend:
- mehrere Schaltanlagenzellen (10, 10', 10"), wobei die Zellen (10, 10', 10") nebeneinander angeordnet sind und ein System von Stromschienen (8) umfassen, wobei die Hochspannungsschaltanlagenzellen (10, 10', 10") mithilfe standardisierter Anschlussschnittstellen (15) verbunden sind, und
- eine Messvorrichtung (20), die dazu eingerichtet ist, mit einer Stromschiene des Systems von Stromschienen (8) einer Schaltanlagenzelle (10) von den mehreren Schaltanlagenzellen (10, 10', 10") verbunden zu werden, wobei die Messvorrichtung umfasst:
- eine Umhüllung (21) aus Isoliermaterial,
- eine elektrische Messschaltung (22) und
- einen Leistungsleiter (23), der mit der elektrischen Schaltung (22) verbunden ist, **dadurch gekennzeichnet, dass**:
die elektrische Messschaltung (22) ins Innere der Umhüllung integriert ist, und dadurch, dass die Umhüllung (21) einen kegelstumpfförmigen Hohlraum (26) aufweist, wobei der Leistungsleiter (23) in der Mitte des kegelstumpfförmigen Hohlraums über die Umhüllung übersteht, und dadurch, dass der kegelstumpfförmige Hohlraum (26) dazu eingerichtet ist, mit einer komplementären Kegelstumpfform eines ersten Endes einer Verbindungshülse (30) einer Anschlussschnittstelle (15) der Schaltanlagenzelle (10) zusammenzuwirken, um so den Leistungsleiter (23) mit einem zentralen leitenden Element in der Verbindungshülse (30) elektrisch zu verbinden,
und dadurch, dass die Messvorrichtung (20) dazu eingerichtet ist, sich mit der Stromschiene (8) der Schaltanlagenzelle (10) zu verbinden, indem sie direkt die Anschlussschnittstelle (15) verwendet, die an den Seiten aller Schaltanlagenzellen (10, 10', 10") angeordnet ist,
und dadurch, dass die Anschlussschnittstelle (15) einen Isolierkörper (11) umfasst, der einen kegelstumpfförmigen Hohlraum (16) aufweist, der dazu eingerichtet ist, mit einer komplementären Kegelstumpfform eines zweiten Endes der Verbindungshülse (30) zusammenzuwirken,
und dadurch, dass ein Leistungsleiter (13) in der Mitte des kegelstumpfförmigen Hohlraums (16) über den Isolierkörper (11) übersteht, um so den Leistungsleiter (13) mit dem zentralen leitenden Element der Verbindungshülse (30) elektrisch zu verbinden,
und dadurch, dass der Leistungsleiter (13) mit der Stromschiene (8) der Zelle (10) verbunden ist.

2. Schaltanlage nach Anspruch 1, **dadurch gekennzeichnet, dass** die Messvorrichtung ein Spannungssensor vom Typ LPVT (Low Power Voltage Transformer) ist.

3. Schaltanlage nach Anspruch 1, **dadurch gekennzeichnet, dass** die Messvorrichtung ein Temperatursensor ist.

4. Schaltanlage nach Anspruch 1, **dadurch gekennzeichnet, dass** die Messvorrichtung (20) eine Befestigungshalterung (27) umfasst, die es ermöglicht, die Messvorrichtung (20) mechanisch an der Anschlussschnittstelle (15) zu befestigen.

5. Schaltanlage nach Anspruch 1, **dadurch gekennzeichnet, dass** die Umhüllung eine L-förmig abgewinkelte Form aufweist, mit einem Winkel (29), der zwischen einem ersten Teilstück, das den kegelstumpfförmigen Hohlraum (26) umfasst, und einem zweiten Teilstück, das die elektrische Schaltung (22) umfasst, positioniert ist.

6. Schaltanlage nach Anspruch 1, **dadurch gekennzeichnet, dass** die Umhüllung aus Epoxidharz oder Polymerharz besteht.

## Claims

1. High-voltage modular switchgear panel comprising:
- a plurality of switchgear cells (10, 10', 10''), the cells (10, 10', 10'') being placed alongside one another and comprising a set of busbars (8), the high-voltage switchgear cells (10, 10', 10'') being linked using standardized coupling interfaces (15), and
- a measuring device (20) suitable for being connected to a busbar of the set of busbars (8) of a switchgear cell (10) of the plurality of switchgear cells (10, 10', 10''), the measuring device comprising:
- an enclosure (21) made of insulating material,
- an electrical measuring circuit (22), and
- a power conductor (23) linked to the electrical circuit (22),
**characterized in that**:
the electrical measuring circuit (22) is incorporated in the enclosure,
and **in that** the enclosure (21) has a cavity (26) of tapered form, the power conductor (23) extending beyond the enclosure at the centre of the tapered cavity, and **in that** the tapered cavity (26) is suitable for cooperating with a complementary tapered form of a first end of a connection sleeve (30) of a coupling interface (15) of the switchgear cell (10), so as to electrically connect the power conductor (23) to a central conductor element in the connection sleeve (30),
and **in that** the measuring device (20) is suitable for being connected to the busbar (8) of the switchgear cell (10) by directly using the coupling interface (15) which is placed on the sides of all the switchgear cells (10, 10', 10''),
and **in that** said coupling interface (15) comprises an insulating body (11) which has a cavity of tapered form (16) suitable for cooperating with a complementary tapered form of a second end of the connection sleeve (30),
and **in that** a power conductor (13) extends beyond the insulating body (11) at the centre of the tapered cavity (16), so as to electrically connect the power conductor (13) to the central conductor element of the connection sleeve (30),
and **in that** the power conductor (13) is coupled with the busbar (8) of the cell (10).

2. Switchgear panel according to Claim 1, **characterized in that** the measuring device is a voltage sensor of the LPVT (Low Power Voltage Transformer) type.

3. Switchgear panel according to Claim 1, **characterized in that** the measuring device is a temperature sensor.

4. Switchgear panel according to Claim 1, **characterized in that** the measuring device (20) comprises a fixing support (27) making it possible to mechanically fix the measuring device (20) to the coupling interface (15).

5. Switchgear panel according to Claim 1, **characterized in that** the enclosure has an L-shaped bent form with a bend (29) positioned between a first part comprising the tapered cavity (26) and a second part comprising the electrical circuit (22).

6. Switchgear panel according to Claim 1, **characterized in that** the enclosure is made of epoxy or polymeric resin.
